# FASCICULE DE BREVET EUROPEEN

(11) **EP 1 236 273 B1**
(45) Date de publication et mention de la délivrance du brevet: **20.08.2003**
(21) Numéro de dépôt: 00985323.5
(22) Date de dépôt: 24.11.2000
(51) Int. Cl.: H03F 3/08, H01L 31/167

(54) **CIRCUIT HYBRIDE HAUTE TENSION**
HOCHSPANNUNGSHYBRIDSCHALTUNG
HIGH VOLTAGE HYBRID CIRCUIT

(30) Priorité: 26.11.1999 FR 9914934
(43) Date de publication de la demande: 04.09.2002
(73) Titulaire: CENTRE NATIONAL DE LA RECHERCHE SCIENTIFIQUE (CNRS), 75794 Paris Cedex 16 (FR)
(72) Inventeur: MEDALE, Jean-Louis, F-31320 Vigoulet Auzil (FR); AOUSTIN, Claude, F-31400 Toulouse (FR); COUTELIER, Jacques, F-31750 Escalquens (FR); SOULEILLE, Pierre, F-31750 Escalquens (FR)
(74) Mandataire: Breese, Pierre
(86) Numéro de dépôt international: FR0003290
(87) Numéro de publication internationale: WO01039368

(56) Documents cités:
- EP-A- 0 646 973
- WO-A-96/08857
- US-A- 3 652 859
- US-A- 5 545 893
- GOODENOUGH F: "INNOVATIVE CIRCUITS CREATE 20-MA 20-KV IC OP AMP" ELECTRONIC DESIGN,US,PENTON PUBLISHING, CLEVELAND, OH, vol. 41, no. 2, 21 janvier 1993 (1993-01-21), pages 31-32, XP000335827 ISSN: 0013-4872 cité dans la demande

## Description

La présente invention concerne le domaine des circuits électroniques haute tension et basse puissance, en particulier des circuits amplificateurs ou des alimentations programmables.

On connaît dans l'état de la technique des dispositifs de commande haute tension, mettant en oeuvre des tubes électroniques. De tels dispositifs nécessitent des puissances de chauffage importantes pour le chauffage des filaments. Leur taille et leur encombrement est relativement important.

On connaît également dans l'état de la technique des circuits optocoupleurs basse-tension.

Le brevet EP646973 concerne un optocoupleur intégré basse tension, destiné à réaliser une isolation électrique entre un signal d'entrée et un signal de sortie.

Le brevet WO96/08857 est également un optocoupleur à basse tension présentant un rapport signal sur bruit amélioré.

Le brevet FR2566978 concerne un récepteur optoélectronique pour transmission par fibre optique.

L'article « INNOVATIVE CIRCUITS CREATE 20-MA 20 KV IC OP AMP » parue dans ELECTRONIC DESIGN janvier 21, 1993 décrit un optocoupleur mettant en oeuvre plusieurs étages reliés en série, chaque étage comportant une diode basse-tension couplé optiquement à une seule diode émettrice. Un tel dispositif ne divulgue pas l'invention, et présente un encombrement excessif pour certaines applications.

La présente invention vise à remédier à ces inconvénients en proposant un circuit miniaturisé apte à fonctionner à des tensions supérieures à 6000 volts.

A cet effet, l'invention concerne selon son acception la plus générale un circuit hybride à semi-conducteur modulable par un courant de commande pour le pilotage de hautes tensions comportant au moins une seule diode haute tension polarisée en inverse entourée par au moins deux diodes émettant un rayonnement infrarouge alimentées par le courant de commande et disposées pour permettre une interaction optique avec la diode haute tension, lesdites diodes étant intégrés dans un boîtier rempli d'une résine isolant d'encapsulation présentant un taux de transmission élevé en dans le domaine des infrarouges. La résine d'encapsulation est choisie parmi les résines présentant un indice optique identique à celui du matériau utilisé pour les diodes. La résine est revêtue par un matériau opaque dans l'infrarouge.

Avantageusement, les diodes de modulation infrarouge sont disposées transversalement, avec un axe d'émission radial par rapport à l'axe principal de la diode haute-tension.

Selon un mode de réalisation avantageux, la diode haute tension et les diodes infrarouge sont disposées dans un boîtier en un matériau réfléchissant dans les infrarouges, ledit boîtier étant rempli par une résine époxyde.

De préférence, les diodes électroluminescentes infrarouges émettent un rayonnement d'environ 880 nanomètres.

Selon un mode de réalisation préféré, les diodes électroluminescentes infrarouges sont connectées en série.

Avantageusement, le boîtier est réalisé en résine époxyde chargé par un matériau à base d'oxyde de Titane ou d'autres charges ayant des propriétés de réflexion dans l'infrarouge.

L'invention concerne également un amplificateur haute tension caractérisé en ce qu'il comporte au moins un circuit hybride conforme à l'invention, commandé par un signal d'entrée alimentant les diodes électroluminescentes infrarouges, et délivrant un signal de sortie commandé par la diode haute tension alimentée par un courant inverse.

Elle concerne également une alimentation programmable haute tension caractérisé en ce qu'elle comporte au moins un circuit hybride conforme à l'invention, commandé par un signal ajustable alimentant les diodes électroluminescentes infrarouges, et délivrant un signal de sortie commandé par la diode haute tension alimentée par un courant inverse.

L'invention sera mieux comprise à la lecture de la description qui suit, se référant à un exemple non limitatif de réalisation et aux figures annexées où :
- la figure 1 représente une vue en coupe d'un optocoupleur selon l'invention ;
- la figure 2 représente une la courbe de réponse de la diode haute tension ;
- la figure 3 représente une vue schématique d'un tel optocoupleur ;
- la figure 4 représente le schéma de principe d'un amplificateur haute tension.

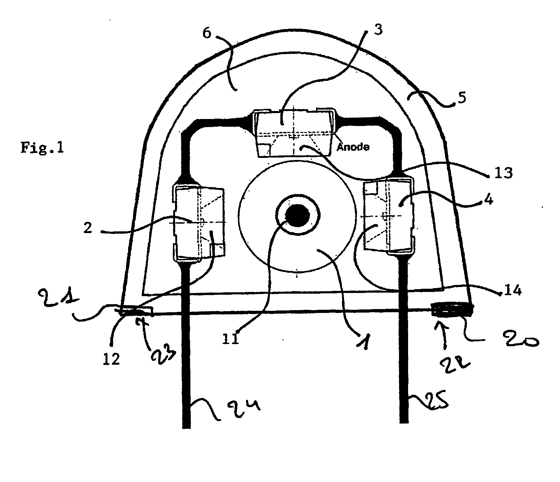

La figure 1 représente une vue en coupe d'un optocoupleur selon un exemple non limitatif de l'invention.

Le dispositif comporte une diode haute tension (1) entourée de trois diodes électroluminescentes (2 à 4). Ces diodes sont reliées en série, et sont commandées par un signal de commande ayant une amplitude de 5 volts.

Les diodes (1 à 4) sont enrobées dans une résine de type époxyde, époxy ou polyuréthane.

Selon une première variante, elles sont disposées dans un boîtier (5) réfléchissant dans la bande de fonctionnement des diodes. Le boîtier est réalisé en un matériau à base d'oxyde de Titane.

L'espace intérieur de ce boîtier est rempli avec une résine époxyde (6) assurant l'isolement électrique et le couplage optique. La résine époxyde est choisie pour présenter un indice optique identique à celui des diodes.

Selon une autre réalisation, les diodes sont moulées dans une résine revêtue par peinture ou par enrobage avec une résine comportant des charges réfléchissantes dans l'infrarouge :
- zincate de titane
- oxyde de titane.

Deux éléments (20, 21) présentant des surfaces inférieures (22, 23) sont moulés dans la résine (6) pour former, du coté des pattes de connexion (24, 25) un plan de référence.

La diode (1) est une diode haute tension de forme générale cylindrique. Il s'agit par exemple d'une diode commercialisée par la société SEMTECH sous les références SM40, SM50, SM75 ou SM100, dont l'enrobage opaque a été retiré, pour permettre la sensibilité au rayonnement infrarouge.

Cette diode (1) est entourée de trois diodes électroluminescentes (2 à 4), par exemple des diodes commercialisées par la société SIEMENS sous les références SFH421 ou SFH426. Ces diodes présentent une fenêtre dont la normale (12 à 14) est orientée radialement par rapport à l'axe longitudinal (11) de la diode haute tension (1).

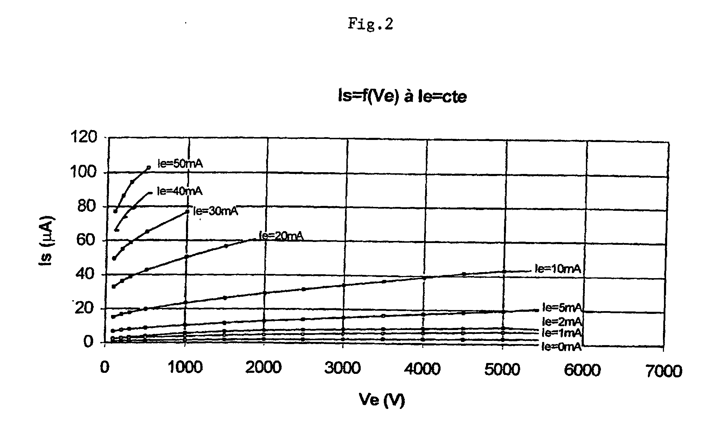

La lumière infrarouge émise par les diodes (2 à 4) entraîne une augmentation du courant inverse de la diode haute tension (1). Le courant inverse varie entre quelques nanoampères en l'absence d'émission infrarouge, à quelques centaines de micro-ampères lorsque les diodes (2 à 4) sont parcourues par un courant de commande et émettent un rayonnement infrarouge. La diode (1) se comporte donc comme une résistance variable, dont la courbe est représentée en figure 2.

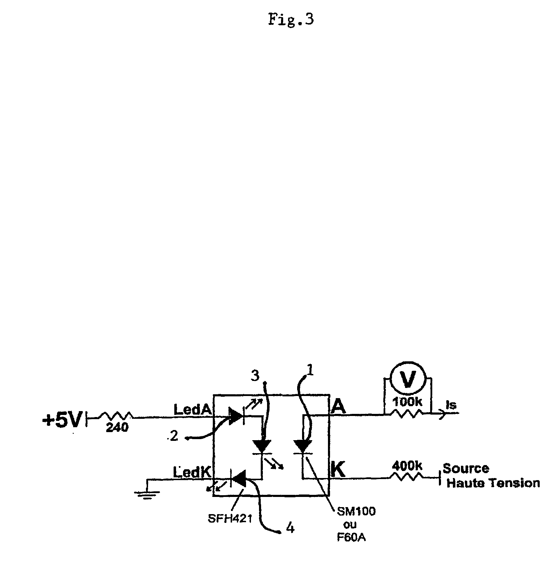

La figure 3 représente un schéma de principe d'un équipement d'un amplificateur utilisant un tel circuit. Les diodes de détection (2 à 4) sont connectées en série.

La diode d'émission (1) est polarisée en sens inverse.

La tension de blocage d'un tel dispositif hybride dépasse 10.000 volts.

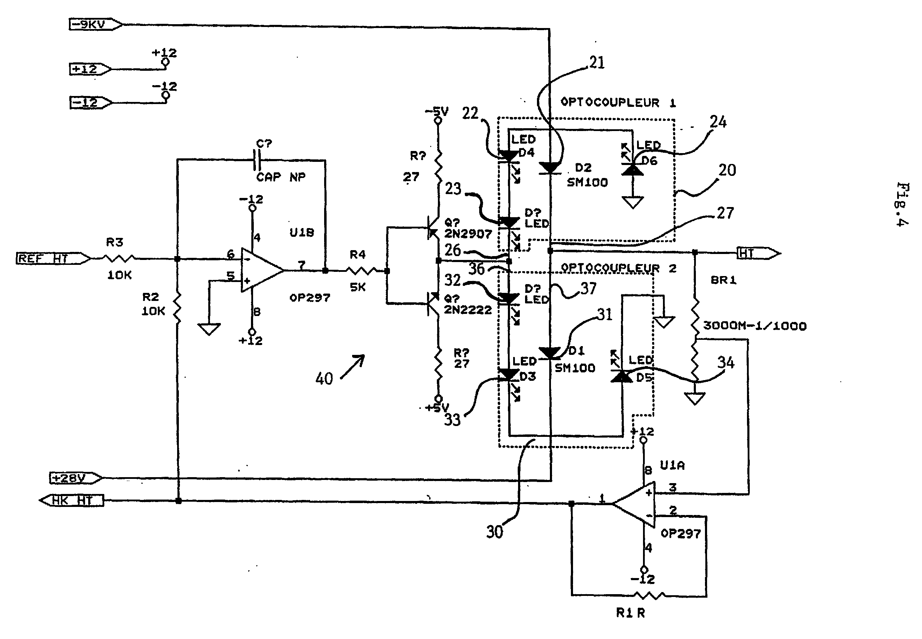

La figure 4 représente le schéma de principe d'une alimentation programmable haute tension mettant en oeuvre deux circuits hybrides (20, 30) conformes à l'invention.

Chacun des circuits hybrides comprend une diode haute tension respectivement (21), (31) entourée de trois diodes électroluminescentes respectivement (22 à 24) et (32 à 34).

Les deux circuits hybrides (20, 30) sont commandés par un signal de commande délivré par un circuit (40).

Les entrées (26, 36) sont reliées en série, ainsi que les sorties (27, 37).

L'invention est décrite dans ce qui précède à titre d'exemple non limitatif. Diverses variantes de réalisation, notamment mettant en oeuvre plus de trois diodes d'émission infrarouge, peuvent être réalisées sans pour autant sortir du cadre de l'invention.

Les applications des dispositifs selon l'invention sont en particulier les suivantes :
- Dispositifs de pilotage de nano-déplacements de systèmes à piezo-actionneurs ;
- Relais haute-tension à faible consommation pour applications opto-électroniques
- Alimentation stabilisée bipolaire à haute tension
- Amplificateur unipolaire ou bipolaire
- Polarisation de plaques dans un détecteur
- Amplificateur opérationnel haute-tension
- Asservissement de tubes photo-détecteurs à haute tension.

## Revendications

1. Circuit hybride à semi-conducteur modulable par un courant de commande pour le pilotage en tension, **caractérisé en ce qu'**il comporte une diode haute tension unique (1) polarisée en inverse entourée par au moins deux diodes émettant un rayonnement infrarouge (2 à 4) alimentées en série par le signal de commande et disposées pour permettre une interaction optique avec la diode haute tension (1), lesdites diodes (1 à 4) étant encapsulées dans un boîtier rempli d'une résine d'enrobage (6) laquelle présente un taux de transmission élevé dans l'infrarouge et est revêtue par un matériau (5) réflecteur dans l'infrarouge.

2. Circuit hybride selon la revendication principale **caractérisé en ce que** les diodes émettant un rayonnement infrarouge sont disposées transversalement, avec un axe d'émission radial par rapport à l'axe principal de la diode haute-tension.

3. Circuit hybride selon la revendication 1 ou 2 **caractérisé en ce qu'**il est revêtu par une résine comportant des charges ayant des propriétés de réflexion dans l'infrarouge.

4. Circuit hybride selon l'une quelconque des revendications 1 à 3 **caractérisé en ce que** les diodes électroluminescentes infrarouges (2 à 4) émettent un rayonnement d'environ 880 nanomètres.

5. Circuit hybride selon l'une des revendications précédentes **caractérisé en ce que** l'indice optique de la résine d'enrobage (6) est identique à l'indice optique des diodes.

6. Circuit hybride selon la revendication 1 **caractérisé en ce que** le revêtement est réalisé en un matériau à base d'oxyde de Titane.

7. Amplificateur haute tension **caractérisé en ce qu'**il comporte au moins un circuit hybride conforme à la revendication 1 commandé par un signal d'entrée alimentant les diodes électroluminescentes infrarouge, et délivrant un signal de sortie commandé par la diode haute tension alimentée par un courant inverse.

8. Alimentation programmable haute tension **caractérisée en ce qu'**elle comporte au moins un circuit hybride conforme à la revendication 1 commandée par un signal ajustable alimentant les diodes électroluminescentes infrarouge, et délivrant un signal de sortie commandé par la diode haute tension alimentée par un courant inverse.

## Patentansprüche

1. Hybrid-Halbleiterkreis, der zur Spannungssteuerung durch einen Steuerstrom modulierbar ist, **dadurch gekennzeichnet, dass** er eine einzige, umgekehrt gepolte Hochspannungsdiode (1) umfasst, welche von mindestens zwei infrarote Strahlung emittierenden Dioden (2 bis 4) umgeben ist, welche vom Steuersignal serienweise versorgt werden und so angeordnet sind, dass sie eine optische Interaktion mit der Hochspannungsdiode (1) erlauben, wobei die besagten Dioden (1 bis 4) in einem Gehäuse eingekapselt sind, welches mit einem Umhüllungsharz (6) gefüllt ist, welcher einen hohen Übertragungsgrad im infraroten Bereich aufweist und mit einem im infraroten Bereich reflektierenden Stoff (5) verkleidet ist.

2. Hybrid-Kreis nach dem Hauptanspruch, **dadurch gekennzeichnet, dass** die eine infrarote Strahlung emittierenden Dioden quer angeordnet sind, mit einer radialen Emittierungsachse hinsichtlich der Hauptachse der Hochspannungsdiode.

3. Hybrid-Kreis nach Anspruch 1 oder 2, **dadurch gekennzeichnet, dass** er mit einem Harz verkleidet ist, welcher Ladungen mit Reflexionseigenschaften im infraroten Bereich aufweist.

4. Hybrid-Kreis nach einem der Ansprüche 1 bis 3, **dadurch gekennzeichnet, dass** die infrarot elektrolumineszenten Dioden (2 bis 4) eine Strahlung von etwa 880 Nanometern emittieren.

5. Hybrid-Kreis nach einem der vorangehenden Ansprüche, **dadurch gekennzeichnet, dass** der optische Index des Umhüllungsharzes (6) dem optischen Index der Dioden gleicht.

6. Hybrid-Kreis nach Anspruch 1, **dadurch gekennzeichnet, dass** die Verkleidung aus einem Stoff auf Titanoxydbasis hergestellt ist.

7. Hochspannungsverstärker, **dadurch gekennzeichnet, dass** er mindestens einen mit dem Anspruch 1 übereinstimmenden Hybrid-Kreis umfasst, welcher von einem Eingangssignal gesteuert wird, das die infrarot elektrolumineszenten Dioden versorgt, und ein Ausgangssignal abliefert, welches von der von einem umgekehrten Strom versorgten Hochspannungsdiode gesteuert wird.

8. Programmierbare Hochspannungsversorgung, **dadurch gekennzeichnet, dass** sie mindestens einen mit dem Anspruch 1 übereinstimmenden Hybrid-Kreis umfasst, welche von einem einstellbaren Signal gesteuert wird, das die infrarot elektrolumineszenten Dioden versorgt, und ein Ausgangssignal abliefert, welches von der von einem umgekehrten Strom versorgten Hochspannungsdiode gesteuert wird.

## Claims

1. Multichip integrated circuit chip with semi-conductor variable by means of a control current for the voltage drive, **characterized in that** it comprises a single high-voltage diode (1) with inverted polarity surrounded by at least two diodes emitting infrared radiation (2 to 4) supplied in series by the control signal and arranged to allow an optical interaction with the high-voltage diode (1), said diodes (1 to 4) being encapsulated in a case filled with a matrix resin (6), which has a high transmission rate in the infrared and which is lined with a reflecting material (5) in the infrared.

2. Multichip integrated circuit according to the primary claim, **characterized in that** the diodes emitting infrared radiation are arranged transversally, with a radial transmission axis with respect to the major axis of the high-voltage diode.

3. Multichip integrated circuit according to Claim 1 or 2, **characterized in that** it is lined with a resin comprising charges with reflecting properties in the infrared.

4. Multichip integrated circuit according to one of the Claims 1 to 3, **characterized in that** the electroluminescent infrared diodes (2 to 4) emit approximately 880 nanometers of radiation.

5. Multichip integrated circuit according to one of the preceding claims, **characterized in that** the optical index of the matrix resin (6) is identical to the optical index of the diodes.

6. Multichip integrated circuit according to Claim 1, **characterized in that** the lining is produced from a material based on titanium dioxide.

7. High-voltage amplifier, **characterized in that** it comprises at least one multichip integrated circuit in conformity with Claim 1, which is controlled by an input signal supplying the electroluminescent infrared diodes, and delivering an output signal controlled by the high-voltage diode supplied by an inverted current.

8. Programmable high-voltage power supply, **characterized in that** it comprises at least one multichip integrated circuit in conformity with Claim 1, controlled by an adjustable signal supplying the electroluminescent infrared diodes, and delivering an output signal controlled by the high-voltage diode supplied by an inverted current.
